Europäisches Patentamt

European Patent Office

Office européen des brevets

(11) Publication number: **0 033 496**
**B1**

(12) EUROPEAN PATENT SPECIFICATION

(45) Date of publication of patent specification: 03.07.85

(21) Application number: **81100497.7**

(22) Date of filing: **23.01.81**

(51) Int. Cl.⁴: **H 01 L 29/72**

(54) Three-terminal semiconductor device.

(30) Priority: **04.02.80 US 118171**

(43) Date of publication of application:
**12.08.81 Bulletin 81/32**

(45) Publication of the grant of the patent:
**03.07.85 Bulletin 85/27**

(84) Designated Contracting States:
**DE FR GB IT**

(56) References cited:
**DE-B-1 257 977**
**FR-A-2 394 174**
**US-A-4 127 861**

(73) Proprietor: **International Business Machines
Corporation
Old Orchard Road
Armonk, N.Y. 10504 (US)**

(72) Inventor: **Heiblum, Mordehai
2375 Mark Road
Yorktown Heights N.Y. 10598 (US)**

(74) Representative: **Gaugel, Heinz, Dipl.-Ing.
Schönaicher Strasse 220
D-7030 Böblingen (DE)**

Courier Press, Leamington Spa, England.

## Description

The technical field of the invention is that of semiconductor devices that perform amplification with very wide bandwidth and switching in the $10^{-12}$ second range.

As performance advantages in semiconductor devices are identified, speed of response has been a limiting factor and efforts have been set forth to reduce the dimensions of the devices and increase carrier velocity so as to reduce the transit time of the carriers. With such efforts, however, have come difficulty in manufacture and serious restrictions in the magnitude of voltages in operation.

One particularly high-speed device was reported in *PROC. IRE*, Vol. 50, p. 1527, 1962. The device was composed of two Schottky barrier diodes back-to-back on a metal base. The device, however, was limited in that a long traverse time was required for the carriers to pass through the depletion layer in the emitter and a long capacitive charging time was required for the emitter rectifying contact.

A need is present in the art for a device of this type wherein such disadvantages are avoided.

Figs. 1, 2 and 3 are a dimensionally correlated illustration of the device of the invention wherein Fig. 1 is a structural schematic.

Fig. 2 is an energy level diagram, and

Fig. 3 is an energy level diagram under the influence of bias.

Fig. 4 is a graph of the output electrical performance of the device of the invention.

Fig. 5 is a graph of the input electrical performance of the invention.

Fig. 6 is an energy level diagram illustrating a modification of the device of the invention.

Fig. 7 is a level energy diagram of the device of Fig. 6 under the influence of bias.

The invention as claimed concerns a semiconductor device having emitter and collector regions, each forming separated rectifying contact with a base region, said base region having high conductivity and a separation dimension from said emitter to said collector that of the order of the length of the mean free carrier path. It is characterized by said emitter region having in a first section adjacent to an ohmic contact a source of carriers positioning the conduction band of said semiconductor material below the Fermi level in said first section, and in a second section adjacent to said base region providing a barrier of a first magnitude and having a dimension of the order of the length of the mean free path of an electron, and said collector region having a barrier to electron flow of a second magnitude greater than said first magnitude.

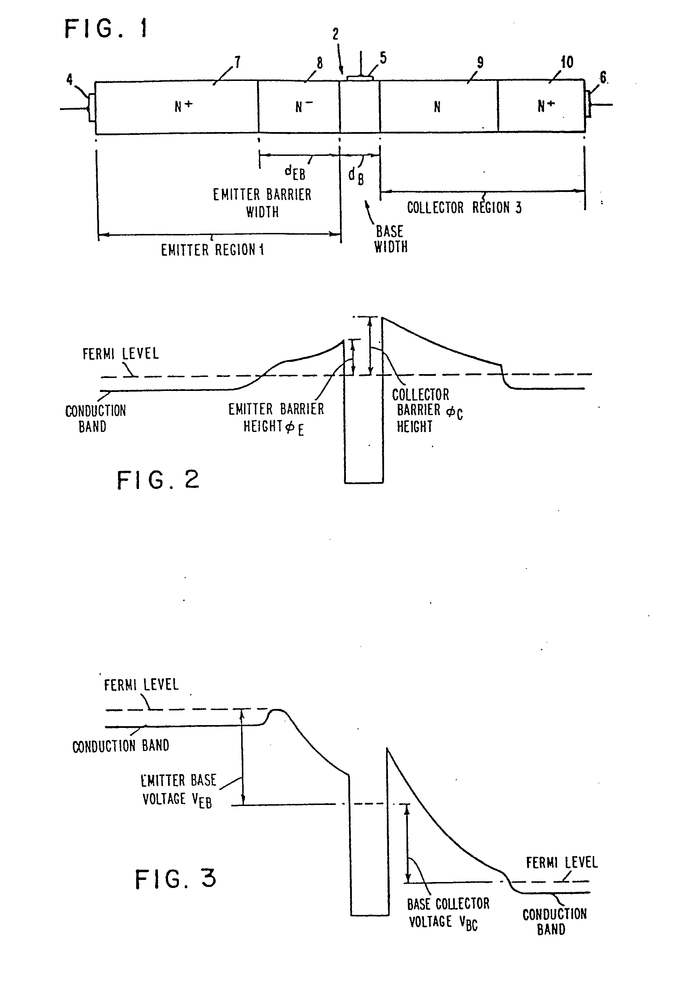

Referring to Fig. 1, a schematic structural illustration of an embodiment of the invention is provided having an emitter region 1, a base region 2 and a collector region 3, each in turn having respectively an emitter external connection 4, a base external connection 5 and a collector external connection 6. The emitter region 1 is made up of two sections 7 and 8. The first emitter section 7 serves as a large supply of carriers, is labelled $N^+$ and may be conveniently formed by heavy doping. The second emitter section 8 provides a low barrier to injected carrier flow into the base region 2. The emitter section 8 is labelled $N^-$ and may be formed by lightly doping within the section defined by the width dimension labelled $d_{EB}$.

The base region 2 is made of high conductivity material such as metal having a width in the vicinity of the length of the mean free path of an electron so that carrier transit time and the number of collisions are minimized.

The collector region is made up of a first section 9, labelled N, forming a barrier to carrier flow in the base. The collector barrier is higher than the barrier that is formed by the emitter section 8. The collector region 3 also has a second collector section 10 labelled $N^+$ which serves to keep the collector resistance and ohmic contact resistance low, and which may be concurrently fabricated by heavier doping. The N, $N^+$ and $N^-$ designations in Fig. 1 are provided to indicate relative doping with conductivity type determining impurities. The criteria of the collector region 3 are satisfied by the Schottky barrier type contact known in the art.

Referring next to Fig. 2 an energy level diagram dimensionally correlated with the structure of Fig. 1 is provided showing in a first portion corresponding to the section 7 of Fig. 1, a condition wherein the conduction band is below the Fermi level thereby providing a large reservoir of carriers. In a second portion corresponding to section 8 of Fig. 1 as the emitter barrier width labelled $d_{EB}$, the number of available carriers is reduced such as by light doping. This has the effect that the conduction band then rises and produces barrier height labelled $\phi_E$. The height of the barrier is controlled by the semiconductor metal interface. It should be noted, however, that for very small values of emitter barrier with the doping level of the reservoir of carriers in section 7 asserts some control. The adjacent high conductivity metal base 2 operates to establish the conduction band at a lower level and reduces the base spreading resistance.

The width of the metal base is in the vicinity of the length of the mean free path of an electron to minimize transit time and number of collisions. The collector barrier height $\phi_C$ is illustrated. The collector barrier height $\phi_C$ is higher than the emitter barrier height $\phi_E$. The conduction band then parabolically becomes lower through the Fermi level as a result of the heavy doping of collector section 10 thereby to reduce collector resistance and minimize contact resistance.

The structure of the invention as described in connection with Figs. 1 and 2 when biased, injects carriers from a large supply over a small barrier where they travel ballistically as hot electrons directly to the collector. The metal base 2 adjacent to the section 8 which is a lightly doped thin dimensioned semiconductor section operates to provide a low barrier and an immediate potential drop to an injected carrier. The advantages of a low base spreading resistance with an injection barrier are thus simultaneously provided.

Under conditions of forward bias of the emitter and reverse bias of the collector, the energy level diagram of the device is illustrated in Fig. 3.

Referring to Fig. 3, in the emitter section 7, a large quantity of carriers is present where the conduction band is lower than the Fermi level. The application of bias shown as $V_{EB}$ produces a potential barrier in the vicinity of the interface of the thin emitter section 8 while the potential drops toward that of the base 2. Under these conditions, the carriers once having traversed the barrier now can traverse both the semiconductor region and the base region directly because the section 8 and the base 2 are each less than the length of the mean free path of an electron passing over the collector barrier the height of which, $\phi_C$, has been selected for collection by choice of materials.

Thus the invention operates by providing a large source of carriers impeded by a low thin barrier in the emitter adjacent to a metal base so that having traversed the barrier, the carriers are accelerated by the potential drop toward the base and due to the thin emitter and base regions, transit time to the collector barrier is short.

Under conditions of a base-emitter bias voltage greater than that which the thin emitter section 8 will support, it is advisable to operate the device in pulse mode.

The criteria of the structure of the invention can be met in fabrication by a number of semi-conductor process techniques. The technique of molecular beam epitaxy is favored for its controllability.

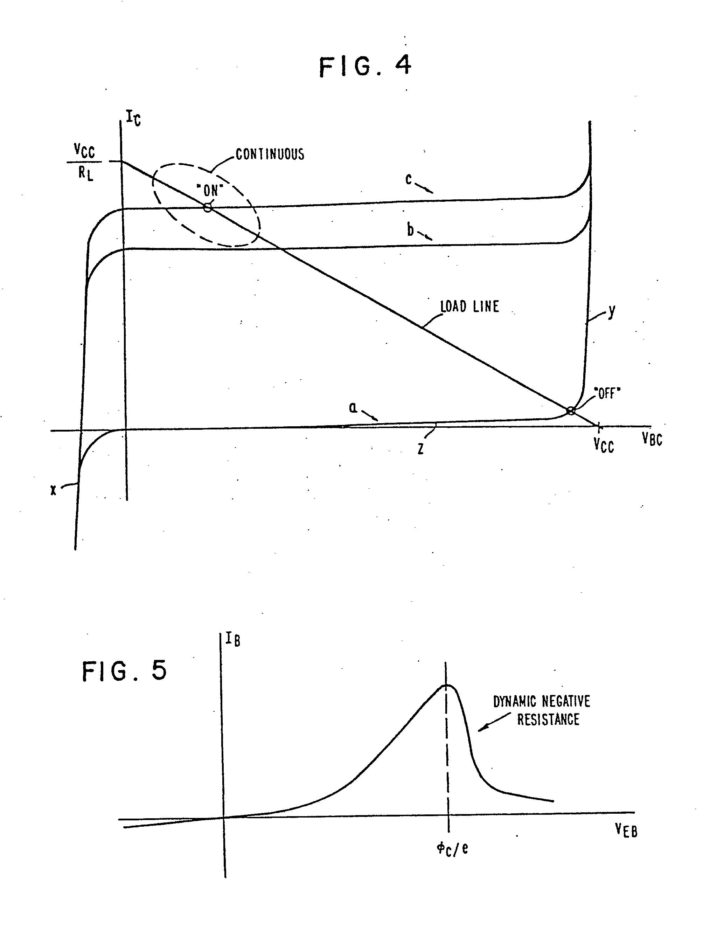

Referring next to Fig. 4, an output performance graph is provided illustrating the operating characteristics under the influence of bias in what is known for three-terminal devices as the common base operation. Operating curves labelled a, b and c are provided for three illustrative levels of emitter-base bias $V_{EB}$. The curve a is for the condition $0<V_{EB}<\phi_{c/e}$. The curve b is for the condition $V_{EB}+0.1$ V. The curve c is for the condition $V_{EB}+0.2$ V.

In the graph of Fig. 4 for negative $V_{BC}$, the various operating curves merge into a single line labelled x, defined by the forward characteristics of the emitter barrier. Similarly, for positive values of $V_{BC}$ the various operational curves merge to a single line labelled y, defined by the breakdown voltage of the reversely biased collector barrier. The slope of the performance curves in the region z closely parallel to the ordinate, are defined by the reverse saturation current of the collector barrier. The load line crosses the operating curves at two points, which when the device is used in a switching mode define the "on" or "off" conditions.

A dotted line encompasses a range for continuous operation. The continuous operation range is defined by the conditions where the emitter-base bias voltage is greater than the collector barrier height divided by e.

Referring next to Fig. 5 which illustrates the input characteristics in the common emitter type of circuit operation, the onset of a dynamic negative resistance is observed at the value of $V_{EB}$ equivalent to the collector barrier height divided by e. As the emitter barrier $V_{EB}$ is increased, the base current increases approximately by the 3-halves power of the increase in the emitter base bias until a value of $V_{EB}$ equivalent to the collector barrier height divided by e is reached, in other words $I_B=I_E\infty V_{EB}^{3/2}$. At this point most of the emitter current will proceed to the collector, the base current will drop and the dynamic negative resistance takes place and the base current then follows a relationship defined by $(1-\alpha)I_E$, the product of the quantity 1 minus $\alpha$, and the emitter current.

The device of Fig. 1 has certain features critical to its operation. For emitter region 1 it is required that there be a first section adjacent to the input terminal that serves as a supplier of carriers, and that there be a semi-conductor section 8 adjacent to a metal base which provides a barrier at the interface with the section 7, and that the second section 8 have a very thin dimension. These conditions may be met by constructing sections 7 and 8 using the material GaAs for the section 7 doped to about $5\times10^{18}$ and for the section 8 reducing the doping to about $10^{15}$.

The semiconductor material chosen for the emitter section 8 should have a wide energy gap so that few thermal carriers will exist in the conduction band.

The emitter current density will be space-charge limited for low voltages and obeys an expression known in the art as "Child's Law", as described in Equation 1.

Equation 1:

$$J=4/9\sqrt{2e/m^*}\ \varepsilon\ V_{EB}^{3/2}/d^2_{EB}$$

where $\varepsilon$ is the dielectric constant.
e is the electron charge.
$m^*$ is the electron effective mass.

The transit time through the emitter region is considered to follow the expression in Equation 2 for the material GaAs.

Equation 2:

$$T=3\sqrt{m^*/2e}\ d_{EB}/V^{1/2}_{EB}$$

An example device constructed of the material may be biased under the conditions set forth in Table I.

TABLE I

| | |
|---|---|
| $m^*/m$ | $=0.07$ |
| $d_{EB}$ | $=200\text{Å}$ |
| $V_{EB}$ | $=0.1$ V |

Under the conditions of Table I the traverse time (T) through the emitter as determined by Equation 2 will be $10^{-13}$ seconds. The traverse time through the metal base will also be $10^{-13}$ seconds where the base width $d_B$ is selected to be 100Å

The collector barrier is of the type known in the art as a Schottky barrier.

The equivalent dynamic resistance of the section 8 of the emitter will follow the expression in Equation 3.

Equation 3:

$$r_{In} \cong \frac{d\ V_{BE}}{d\ I_E} \cong 8\ ohms$$

where $\varepsilon$ is 11.5 $\varepsilon_o$ and the cross sectional area of the device is 1 micron square.

The input time constant of the device of the invention using the example GaAs material is in the vicinity of $0.4 \times 10^{-13}$ seconds so that the speed limitation of the device will be determined by the base-collector barrier which in turn responds in the vicinity of $10^{-13}$ seconds. The emitter base bias voltage will occur mostly across section 8, the thin lightly doped region.

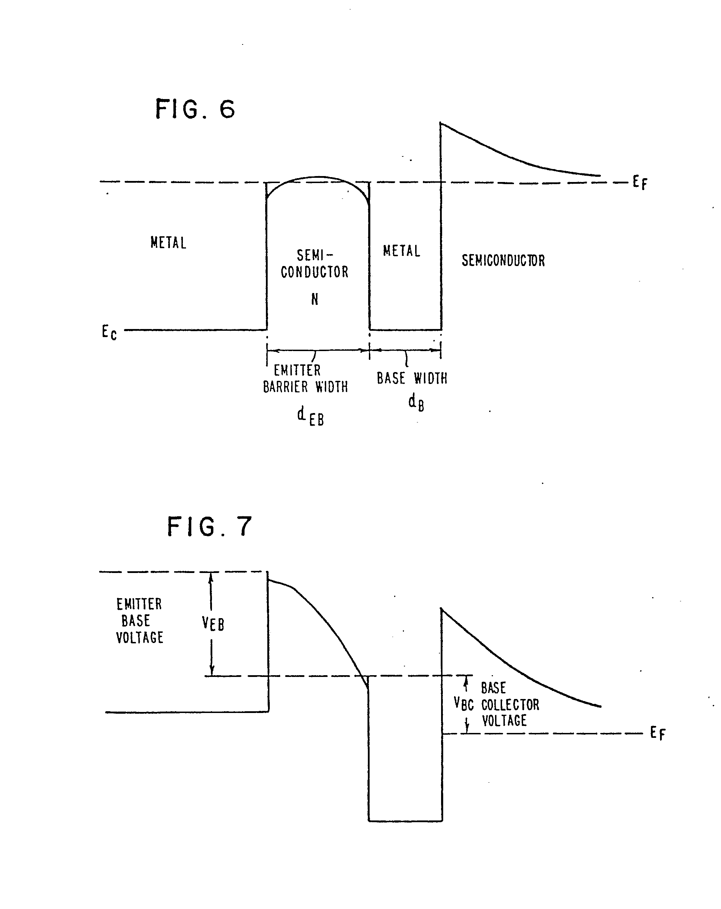

Referring next to Fig. 6, a variation in the structure of Fig. 1 can be provided wherein the section 8 of the emitter region is a semiconductor such as CdS which forms a non-rectifying contact with the base 2 and the emitter. With such a modification the emitter barrier width should be made wide enough that the accumulation layers which make the semiconductor degenerate on both sides next to the interfaces with the metal will not swamp the total film thickness. This is illustrated by the fact that the conduction band potential level arcs up above the Fermi level inside $d_{EB}$. For the material CdS, the dimension for the emitter barrier width should increase to about 600Å.

Referring next to Fig. 7, an energy diagram is provided under the influence of bias. The bias provides carriers from the metal-emitter contact over the barrier in the non-rectifying semiconductor and the thin dimensions of both the emitter barrier region and the base permit the carriers to be accelerated directly over the collector barrier without losing any energy due to electron-electron and electron-phonon collisions.

In both the Fig. 1 and Fig. 6 embodiments, the lightly doped $N^-$ section and the non-rectifying semiconductor CdS section are empty of free carriers and thereby support the potential difference $V_{EB}$. In operation carriers spill over a small barrier at the section 7 section 8 interface or the metal non-rectifying semiconductor CdS interface and then proceed toward the base. Since the thickness of the $N^-$ or example CdS section is close to the length of the mean free path of the electrons, they will reach the base with essentially the same energy they were emitted by, which is $eV_{EB}$, and they will have excess energy above the Fermi level or, in other words, be "hot".

Further, since the base is selected to be thin enough, the electrons will traverse it without collisions and maintain their excess energy so as to surmount the collector barrier $\phi_C$.

It will also be apparent to one skilled in the art that the base-collector combination 9—10 may be replaced by a metal-oxide-metal contact. Such a structure reduces the transient time through the collector. Similarly the metal base 2 of Fig. 1 may be replaced by a heavily doped semiconductor. Such a structure will have the advantages of a controllably grown heterojunction of the emitter region 1 base region 2 interface thereby reducing some deleterious interface properties such as surface states and defects, and provides a longer mean free path in the epitaxial base.

What has been described is a device wherein a large quantity of carriers and a low barrier emitter region is provided adjacent to a thin high conductivity base such as a metal, so that a quantity of carriers can pass the barrier and traverse the base directly to the collector barrier. Since the structure provides conditions where these carriers do not collide in either the thin barrier region of the emitter region or in the thin base, they maintain a quasi mono-energetic current distribution directly to the collector.

**Claims**

1. A semiconductor device having emitter (1) and collector regions (3), each forming separated rectifying contact with a base region (2), said base region having high conductivity and a separation dimension from said emitter to said collector of the order of the length of the mean free carrier path, characterized by said emitter region having in a first section (7) adjacent to an ohmic contact (4) a source of carriers positioning the conduction band of said semiconductor material below the Fermi level in said first section, and in a second section (8) adjacent to said base region (2) providing a barrier of a first magnitude and having a dimension of the order of the length of the mean free path of an electron, and said collector region having a barrier to electron flow of a second magnitude greater than said first magnitude.

2. The device of claim 1, wherein said base region (2) is metal and said collector region (3) is a Schottky barrier contact.

3. The device of claim 1, wherein said base region (2) is a high conductivity crystalline semiconductor.

4. The device of claim 1, wherein said emitter region (1) is doped heavily in said first section (7) and doped lightly in said second section (8).

5. The device of claim 2, wherein said emitter region (1) is GaAs.

6. The device of claim 5, wherein said collector region (3) is metal, separated by oxide from said metal base region (2).

7. A transistor with an emitter region (1), a high conductivity type base region (2) and a collector region (3), said base region (2) having a width of the order of the length of the mean free carrier path, characterized by said emitter region having a first section (7) adjacent to an ohmic contact (4) operable to supply a large source of carriers and a second section (8) positioned between said source of carriers and said base region (2), said second section having a dimension of the order of the length of the mean free carrier path and a carrier distribution such that the conduction band in said second region under the influence of bias is higher at the interface of said first and said second regions than it is at the interface of said second region (8) and said base region (2), said collector region (3) having a barrier greater than the barrier at the emitter/base interface.

8. The transistor of claim 7, wherein said emitter regions (7, 8) are doped GaAs, said base region (2) is metal, and said collector region (3) is a Schottky barrier.

9. The transistor of claim 7, wherein said emitter regions (7, 8) and said base region (2) consist of GaAs with different dopings.

10. The transistor of claim 7, wherein said first emitter region (7) is metal, said second emitter region (8) is CdS, and said base region (2) is metal.

**Revendications**

1. Dispositif semiconduceur comportant une région d'émetteur (1) et une région de collecteur (3) formant chacune des contacts redresseurs séparés avec une région de base (2), ladite région de base présentant une conductivité élevée et une dimension de séparation depuis ledit émetteur jusqu'audit collecteur de l'ordre de la longueur de la course moyenne libre des porteurs, caractérisé en ce que ladite région d'émetteur comporte dans une première section (7) adjacente à un contact ohmique (4), une source de porteurs plaçant la bande de conduction de la matière semiconductrice en dessous du niveau de Fermi dans ladite première section, et, dans une seconde section (8) adjacente à ladite région de base (2) forme une barrière d'une première grandeur et présente une dimension de l'order de la longueur de la course moyenne libre d'un électron, et que ladite région de collecteur présente vis-à-vis du flux d'électrons une barrière d'une seconde grandeur supérieure à ladite première grandeur.

2. Dispositif selon la revendication 1, dans lequel ladite région de base (2) est un métal et ladite région de collecteur (3) est un contact du type barrière de Schottky.

3. Dispositif selon la revendication 1, dans lequel ladite région de base (2) est un semiconducteur cristallin de conductivité élevée.

4. Dispositif selon la revendication 1, dans lequel ladite région d'émetteur (1) est fortement dopée dans ladite première section (7) et légèrement dopée dans ladite seconde section (8).

5. Dispositif selon la revendication 2, dans lequel ladite région d'émetteur (1) est du GaAs.

6. Dispositif selon la revendication 5, dans lequel ladite région de collecteur (3) est du métal, séparé de ladite région de base métallique (2) par un oxyde.

7. Transistor comportant une région d'émetteur (1), une région de base (2) du type à conductivité élevée et une région de collecteur (3), ladite région de base (2) ayant une largeur de l'ordre de la longueur de la course moyenne libre des porteurs, caractérisé en ce que ladite région d'émetteur comporte une première section (7) adjacente à un contact ohmique (4) pouvant fonctionner de manière à former une source importante de porteurs et une seconde section (8) disponsée entre ladite source de porteurs et ladite région de base (2), ladite seconde section présentant une dimension de l'ordre de la longueur de la course moyenne libre des porteurs et une répartition de porteurs telle que la bande de conduction dans ladite seconde région sous l'influence d'une polarisation est plus élevée à l'interface desdites première et seconde régions qu'à l'interface de ladite seconde région (8) et de ladite région de base (2), ladite région de collecteur (3) présentant une barrière plus grande que la barrière à l'interface émetteur/base.

8. Transistor selon la revendication 7, dans lequel lesdites régions d'émetteur (7, 8) sont du GaAs dopées, ladite région de base (2) est du métal, et ladite région de collecteur (3) est une barrière Schottky.

9. Transistor selon la revendication 7, dans lequel lesdites régions d'émetteur (7, 8) et ladite région de base (2) sont constituées de GaAs avec des dopages différents.

10. Transistor selon la revendication 7, dans lequel ladite première région d'émetteur (7) est du métal, ladite seconde région d'émetteur (8) est du CdS, et ladite région de base (2) est du métal.

**Patentansprüche**

1. Halbleitvervorrichtung mit Emitter- (1) und Kollektorbereichen (3), die jeweils getrennten gleichrichtenden Kontakt mit einem Basisbereich (2) herstellen, wobei der Basisbereich von hoher Leitfähigkeit ist und eine trennende Dimension vom Emitter zum Kollektor in der Größenordnung der Länge des mittleren freien Ladungsträgerweges aufweist, dadurch gekennzeichnet, daß der Emitterbereich in einem ersten Teil (7) neben einem ohmschen Kontakt (4) eine Ladungsträgerquelle aufweist, welche das Leitungsband des Halbleitermaterials unter das Fermi-Niveau im ersten Teil positioniert, und in einem zweiten Teil (8) neben dem Basisbereich (2) mit einer Barriere einer ersten Höhe und einer Dimension in der Größenordnung der Länge des mittleren freien Weges eines Elektrons, und wobei der Kollektorsbereich eine Barriere gegen Elektronenfluß einer zweiten Höhe aufweist, die größer ist als die erste Höhe.

2. Vorrichtung nach Anspruch 1, wobei der Basisbereich (2) Metall ist und der Kollektorbereich (3) ein Schottky-Kontakt.

3. Vorrichtung nach Anspruch 1, wobei der Basisbereich (2) ein kristalliner Halbleiter hoher Leitfähigkeit ist.

4. Vorrichtung nach Anspruch 1, wobei der Emitterbereich (1) stark dotiert ist im ersten Teil (7) und leicht dotiert im zweiten Teil (8).

5. Vorrichtung nach Anspruch 2, wobei der Emitterbereich (1) GaAs ist.

6. Vorrichtung nach Anspruch 5, wobei der Kollektorbereich (3) Metall ist, durch Oxid vom metallenen Basisbereich (2) getrennt.

7. Transistor mit einem Emitterbereich (1), einem Basisbereich (2) hoher Leitfähigkeit und einem Kollektorbereich (3), wobei der Basisbereich (2) eine Breite in der Größenordnung der Länge des mittleren freien Ladungsträgerweges aufweist, dadurch gekennzeichnet, daß der Emitterbereich einen ersten Teil (7) neben einem ohmschen Kontakt (4) aufweist, der eine große Ladungsträgerquelle darstellt, sowie einen zweiten Teil (8) zwischen der Ladungsträgerquelle und dem Basisbereich (2), wobei der zweite Teil eine Dimension in der Größenordnung der Länge des mittleren freien Ladungsträgerweges aufweist, und eine Ladungsträgerverteilung, die solcher Art ist, daß das Leitungsband im zweiten Bereich unter dem Einfluß einer Spannung höher ist an der Schnittstelle des ersten und zweiten Bereiches als an der Schnittstelle des zweiten Bereiches (8) und des Basisbereichs (2), wobei der Kollektorbereich (3) eine Barriere hat, die größer ist als die Barriere an der Emitter/Basis-Schnittstelle.

8. Transistor nach Anspruch 7, wobei die Emitterbereiche (7, 8) aus dotierten GaAs bestehen, der Basisbereich (2) aus Metall und der Kollektorbereich (3) eine Schottky-Barriere ist.

9. Transistor nach Anspruch 7, wobei die Emitterbereiche (7, 8) und der Basisbereich (2) aus GaAs mit unterschiedlichen Dotierungen bestehen.

10. Transistor nach Anspruch 7, wobei der erste Emitterberiech (7) Metall ist, der zweite Emitterbereich (8) CdS und der Basisbereich (2) Metall.

FIG. 1

EMITTER BARRIER WIDTH

$d_{EB}$

$d_B$

EMITTER REGION 1

BASE WIDTH

COLLECTOR REGION 3

FIG. 2

FERMI LEVEL

CONDUCTION BAND

EMITTER BARRIER HEIGHT $\phi_E$

COLLECTOR BARRIER $\phi_C$ HEIGHT

FIG. 3

FERMI LEVEL

CONDUCTION BAND

EMITTER BASE VOLTAGE $V_{EB}$

BASE COLLECTOR VOLTAGE $V_{BC}$

FERMI LEVEL

CONDUCTION BAND

# FIG. 4

# FIG. 5

FIG. 6

METAL

SEMI-
CONDUCTOR

N

METAL

SEMICONDUCTOR

$E_F$

$E_C$

EMITTER
BARRIER WIDTH

$d_{EB}$

BASE WIDTH

$d_B$

FIG. 7

EMITTER
BASE
VOLTAGE

$V_{EB}$

BASE
$V_{BC}$ COLLECTOR
VOLTAGE

$E_F$

3